# EUROPEAN PATENT APPLICATION

(11) **EP 4 492 464 A1**
(43) Date of publication of application: **15.01.2025**
(21) Application number: 22879627.2
(22) Date of filing: 17.03.2022
(51) Int. Cl.: H01L 27/12

(54) **FLEXIBLE DISPLAY PANEL**

(30) Priority: 10.03.2022 CN 202210229437
(71) Applicant: Wuhan China Star Optoelectronics Semiconductor Display Technology Co., Ltd., Wuhan, Hubei 430070 (CN)
(72) Inventor: YANG, Guoqiang, Wuhan Hubei 430079 (CN)
(74) Representative: Murgitroyd & Company
(86) International application number: PCT/CN2022/081367
(87) International publication number: WO 2023/168737

(57) **Abstract**

A flexible display panel is provided by the present application, which includes a first organic substrate, a charge passivation layer, a first inorganic layer, and a thin film transistor layer. The charge passivation layer is disposed on a side of the first organic substrate and includes at least one electro-withdrawing group. The first inorganic layer is disposed on a side of the charge passivation layer facing away from the first organic substrate. The thin film transistor layer is disposed on a side of the first inorganic layer facing away from the first organic substrate.

## Description

### BACKGROUND OF THE INVENTION

### Field of Invention

The present application relates to the field of display technologies, and particularly relates to a flexible display panel.

### Description of Prior Art

With rapid development of modern display technologies, the field of display technologies are developed in directions of lighter weight, less thickness, greater flexibility, and greater transparency. Traditional glass substrates hardly meet requirements of future flexible display technologies, due to their characteristics of great hardness and brittleness. Polymer film substrates have characteristics of light weight and high mechanical strength, and meanwhile, based on the requirement for flexibility of display panels, flexible polymer film substrates are first choice materials for flexible display technologies in the future.

However, in practical applications, it is found that image sticking occurs more frequently in display panels with organic flexible polymer materials as substrates than in display panels with glasses as substrates.

### SUMMARY OF INVENTION

In view of this, the present application provides a flexible display panel capable of reducing image sticking.

A flexible display panel is provided, comprising:
a first organic substrate;
a charge passivation layer disposed on a side of the first organic substrate, wherein the charge passivation layer comprises at least one electro-withdrawing group;
a first inorganic layer disposed on a side of the charge passivation layer facing away from the first organic substrate; and
a thin film transistor layer disposed on a side of the first inorganic layer facing away from the first organic substrate.

Optionally, in one embodiment, the charge passivation layer is disposed on a surface of a side of the first organic substrate close to the thin film transistor layer.

Optionally, in one embodiment, the flexible display panel also comprises:
a second inorganic layer disposed between the first organic substrate and the first inorganic layer; and
a second organic substrate disposed between the second inorganic layer and the first inorganic layer;
wherein the charge passivation layer is disposed between the first organic substrate and the second inorganic layer, and/or, the charge passivation layer is disposed between the second organic substrate and the first inorganic layer.

Optionally, in one embodiment, the charge passivation layer is disposed on a surface of a side of the second organic substrate close to the thin film transistor layer.

Optionally, in one embodiment, the charge passivation layer is obtained by performing a charge passivation process on a same organic material as the first organic substrate, or, the charge passivation layer is obtained by performing a charge passivation process on a same organic material as the second organic substrate.

Optionally, in one embodiment, the charge passivation layer is obtained by Fluorination of the same organic material as the first organic substrate, or, the charge passivation layer is obtained by Fluorination of the same organic material as the second organic substrate.

Optionally, in one embodiment, the first organic substrate comprises the same organic material as the second organic substrate.

Optionally, in one embodiment, a dielectric constant of the charge passivation layer is less than or equal to 2.7, and a transmittance of the charge passivation layer of light of 380 nm to 780 nm is greater than or equal to 79%.

In the flexible display panels of the present application, the charge passivation layer containing electro-withdrawing group is formed between the first organic substrate and the thin film transistor layer, the charge passivation layer is able to prevent electrons from moving, so as to prevent charges generated by polarization of the first organic substrate from affecting the thin film transistors arranged thereon, maintaining the electrical stability of the thin film transistors, and reducing image sticking.

### BRIEF DESCRIPTION OF DRAWINGS

In order to more clearly illustrate the technical solution of the present invention, a brief description of the drawings that are necessary for the illustration of the embodiments will be given as follows. Obviously, the drawings described below show only some embodiments of the present invention, and a person having ordinary skill in the art may also obtain other drawings based on the drawings described without making any creative effort.
FIG. 1 is a schematic diagram showing a principle following which polyimides affect electrical properties of thin film transistors in prior art.
FIG. 2 is a schematic diagram showing a principle following which intramolecular and intermolecular CTC of polyimides is formed in the prior art.
FIG. 3 is a schematic diagram showing changes of a threshold voltage of a thin film transistor arranged on polyimides and a thin film transistor arranged on a glass, at different temperatures and voltages.
FIG. 4 is a structural schematic view of a flexible display panel according to a first embodiment of the present application.
(a) of FIG. 5 is an energy dispersive X-ray spectroscopy (EDX) diagram of an fluoropolyimide film of embodiment 1 of the present application, and (b) of FIG. 5 is an element distribution diagram of C, O, and F of the fluoropolyimide film of embodiment 1 of the present application.
(a) of FIG. 6 is an EDX diagram of an fluoropolyimide film of a comparative embodiment of the present application, and (b) of FIG. 6 is an element distribution diagram of C, O, and F of the fluoropolyimide film of the comparative embodiment.

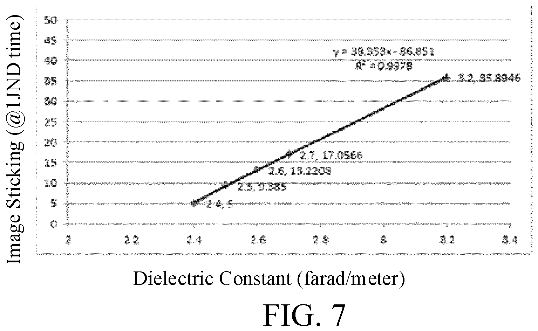

FIG. 7 is a diagram showing a relationship between dielectric constants and long-term image sticking of polyimides in embodiments 1 to 3 and the comparative embodiment.

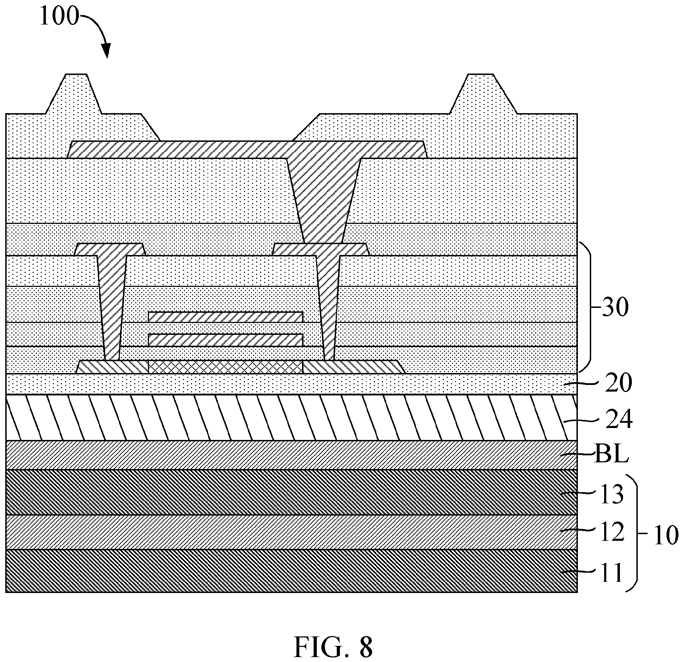

FIG. 8 is a structural schematic view of a flexible display panel according to a second embodiment of the present application.

### DETAILED DESCRIPTION OF PREFERRED EMBODIMENTS

The present disclosure is further described in detail below with reference to the accompanying drawings and embodiments. Obviously, the following described embodiments are only part of the present disclosure but not all. A person having ordinary skill in the art may obtain other embodiments based on the embodiments provided in the present disclosure without making any creative effort, which all belong to the scope of the present disclosure.

In the present application, unless expressly provided and limited, that the first feature is "on" or "under" the second feature may include that the first and second features are directly connected, or not directly connected, but connected through another feature between them. Moreover, that the first feature is "on" or "upon" and "above" the second feature includes that the first feature is directly above or obliquely above the second feature, or only indicates that the horizontal height of the first feature is higher than that of the second feature. Moreover, that the first feature is "below" and "under" the second feature includes that the first feature is directly under or obliquely under the second feature, or only indicates that the horizontal height of the first feature is lower than that of the second feature. Besides, the terms "first", "second" and "third" in the present application are used for descriptive purposes only, and cannot be understood as indicating or implying relative importance or implying numbers of indicated technical features. Thus, a feature defined as "first" and "second" may explicitly or implicitly includes one or more than one such features.

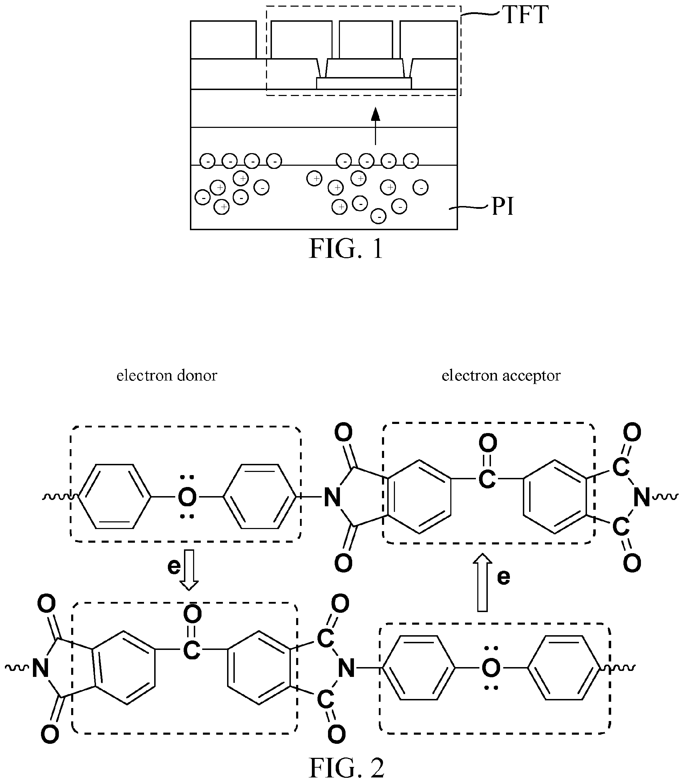

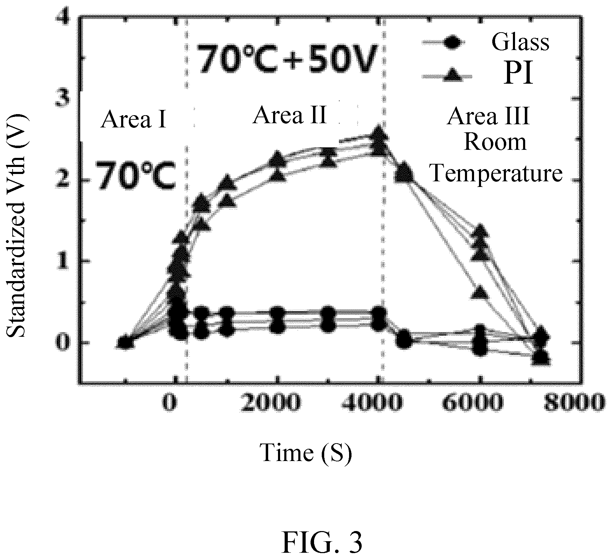

Aiming to solve a problem of image sticking in display panels with organic materials as substrates, inventors do research on polyimide organic substrates as examples. It is found through the research that: at present, materials of polyimide generally used by panel manufacturers are derived from polymer compounds of polyamic acid synthesized from 3,3',4,4'-Biphenyl tetracarboxylic diandhydride (BPDA) and p-Phenylenediamine (p-PDA). These polyimide materials usually have good dimensional stability and mechanical property, but due to a well-ordered arrangement of molecular structures and high molecular packing density, as shown in figure 1, there exist strong intramolecular charge transfer complex (CTC) effect and intermolecular CTC effects. Electrons transfer within a single polyimide molecule and between polyimide molecules, leading to polarization of polyimide materials. As shown in FIG. 2, especially during fabrication of array substrates, the polyimide materials polarize, resulting in charges accumulation on a surface of a polyimide film PI. During operation of the thin film transistor devices TFT arranged on the surface of the polyimide film PI, the charges accumulated on the surface of the polyimide film PI may affect characteristics of the transistor devices TFT, resulting in image sticking during operation of panels. Please refer to FIG. 3, testing on a threshold voltage (Vth) of a thin film transistor arranged on the polyimides and a thin film transistor arranged on a glass, at different temperatures and voltages, is conducted by the inventors, respectively. Experimental results show that under stress of a same temperature and voltage, positive shift of the threshold voltage of the thin film transistor arranged on the polyimide substrate is much greater than positive shift of the thin film transistor arranged on the glass substrate. Moreover, when the stress is gone, the threshold voltage of the thin film transistor arranged on the polyimide substrate quickly returns to an original level, which confirms an influence of charges generated by polyimides on the characteristics of thin film transistors.

A flexible display panel is provided by the present application, which includes a first organic substrate, a charge passivation layer, a first inorganic layer, and a thin film transistor layer, to avoid an influence of polarization of organic materials on electrical properties of thin film transistors. The charge passivation layer is disposed on a side of the first organic substrate and includes at least one electro-withdrawing group. The first inorganic layer is disposed on a side of the charge passivation layer facing away from the first organic substrate. The thin film transistor layer is disposed on a side of the first inorganic layer facing away from the first organic substrate.

In the flexible display panels of the present application, a charge passivation layer containing electro-withdrawing groups is formed between the first organic substrate and the thin film transistor layer, the charge passivation layer is able to prevent electrons from moving, so as to prevent charges generated by polarization of the first organic substrate from affecting the thin film transistors arranged thereon, maintaining electrical stability of the thin film transistors, and reducing image sticking.

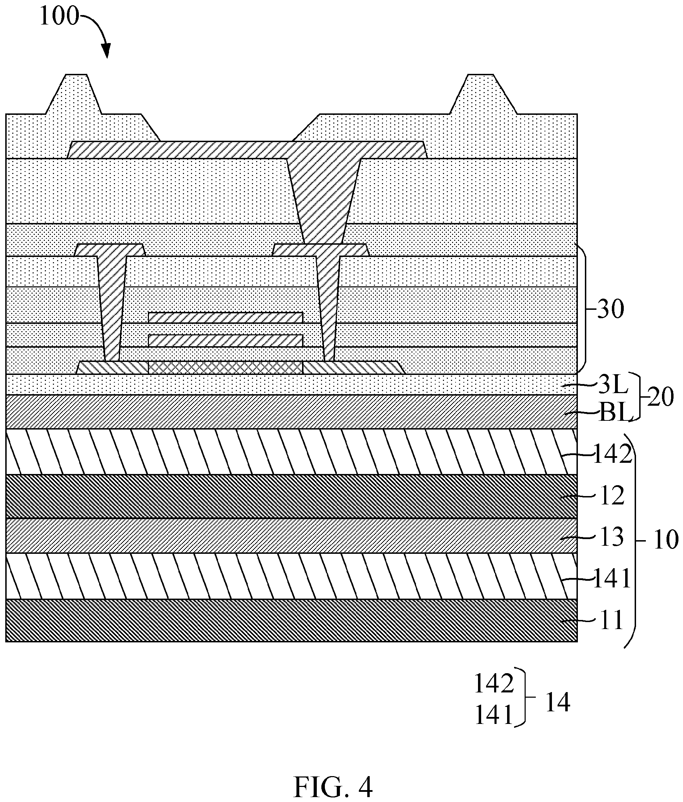

Please refer to FIG. 4, a flexible display panel 100 is provided by one embodiment of the present application. Optionally, the flexible display panel 100 can be an organic light-emitting display panel. The flexible display panel 100 includes a substrate 10, a first inorganic layer 20, and a thin film transistor layer 30. The first inorganic layer 20 is disposed on a side of the substrate 10, and the thin film transistor layer 30 is disposed on a side of the first inorganic layer 20 facing away from the substrate 10.

The substrate 10 includes a first organic substrate 11, a second organic substrate 12, and a second inorganic layer 13 disposed between the first organic substrate 11 and the second organic substrate 12. The second inorganic layer 13 is disposed between the first organic substrate 11 and the first inorganic layer 20. The second organic substrate 12 is disposed between the second inorganic layer 13 and the first inorganic layer 20. The first organic substrate 11 may have a same organic material as the second organic substrate 12. It should be noted that in this embodiment, the organic substrate facing away from the thin film transistor layer 30 of the substrate 10 is called the first organic substrate 11, and the organic substrate close to thin film transistor layer 30 is called the second organic substrate 12, however, in another embodiment, the first organic substrate 11 can be the organic substrate close to thin film transistor layer 30, and the second organic substrate 12 can be the organic substrate facing away from the thin film transistor layer 30.

Optionally, the first inorganic layer 20 includes at least one of a buffer layer BL and a barrier layer 3L. In this embodiment, the first inorganic layer 20 includes the buffer layer BL and the barrier layer 3L. The buffer layer BL includes silicon nitride, silicon oxide, or a stack of silicon nitride and silicon oxide. The barrier layer 3L includes a stack of silicon nitride, silicon oxide, and a-Si.

The flexible display panel 100 further includes a charge passivation layer 14 disposed on a side of the first organic substrate 11 close to the thin film transistor layer 30. The charge passivation layer 14 includes at least one electro-withdrawing group. Optionally, the charge passivation layer 14 is disposed between the first organic substrate 11 and the second inorganic layer 13, and/or the charge passivation layer 14 is disposed between the second organic substrate 12 and the first inorganic layer 20. Furthermore, the charge passivation layer 14 is disposed on a side surface of the first organic substrate 11 close to the thin film transistor layer 30, and/or the charge passivation layer 14 can also be disposed on a side surface of the second organic substrate 12 close to the thin film transistor layer 30.

The charge passivation layer 14 is located between the organic substrate and the thin film transistor layer 30, and polarization of materials of the organic substrates can be prevented from affecting the operation of the thin film transistor layer 30. Furthermore, an inorganic layer can also be disposed between the charge passivation layer 14 and the thin film transistor layer 30, and intrusion of water vapor from the charge passivation layer 14 can be prevented by the inorganic layer.

Optionally, the charge passivation layer 14 is obtained by performing a charge passivation process on a same organic material as the first organic substrate 11, or the charge passivation layer 14 is obtained by performing the charge passivation process on a same organic material as the second organic substrate 12. Furthermore, the charge passivation layer 14 is obtained by fluorination of the same organic material as the first organic substrate 11, or the charge passivation layer 14 is obtained by fluorination of the same organic material as the second organic substrate 12.

Specifically, the charge passivation layer 14 can include a first charge passivation layer 141 and a second charge passivation layer 142. Wherein the first charge passivation layer 141 is disposed between the first organic substrate 11 and the thin film transistor layer 30. Furthermore, the first charge passivation layer 141 is disposed on a side surface of the first organic substrate 11 close to the thin film transistor layer 30. The first charge passivation layer 142 is disposed between the second organic substrate 12 and the thin film transistor layer 30. Furthermore, the second charge passivation layer 142 is disposed on a side surface of the second organic substrate 12 close to the thin film transistor layer 30. Optionally, a thickness of the first organic substrate 11 ranges from 5 microns to 15 microns, and a thickness of the second organic substrate 12 ranges from 5 microns to 10 microns.

In the flowing paragraphs, the first organic substrate 11 and the first charge passivation layer 141 are taken as examples to illustrate the materials of the organic substrate 11 and the charge passivation layer 141. Details about the second organic substrate 12 and the second charge passivation layer 142 can be acknowledged referring to the first organic substrate 11 and the first charge passivation layer 141.

The first charge passivation layer 141 is obtained by performing the charge passivation process on the same organic material as the first organic substrate 11. Specifically, the first charge passivation layer 141 is obtained by fluorination of the same organic material as the first organic substrate 11. It can be understood that the first charge passivation layer 141 is obtained by performing the charge passivation process on the same organic material as the second organic substrate 12. On the contrary, the charge passivation layer 142 is obtained by performing the charge passivation process on the same organic material as the first organic substrate 11.

The material of the first organic substrate 11 is conventional polyimide. The material of the first charge passivation layer 141 is polyimide containing at least one electro-withdrawing group. The at least one electro-withdrawing group contained in the first charge passivation layer 141 is able to trap electrons, stop electrons form moving, so as to fulfil a function of charge passivation. Optionally, the at least one electro-withdrawing group can be selected from at least one of nitro group, trifluoromethyl, trichloromethyl, tribromomethyl, triiodomethyl, cyano group, sulfonic acid group, fluorine atom, chlorine atom, bromine atom, and iodine atom. It should be noted that the material of the first organic substrate 11 can also be one of polyethylene naphthalate (PEN), polyethylene terephthalate (PET), polyarylate (PAR), polycarbonate (PC), polyetherimide (PEI) and polyethersulfone (PES). Accordingly, the material of the first charge passivation layer 141 is the above-mentioned materials containing the at least one electro-withdrawing group.

Optionally, the first charge passivation layer 141 of polyimide containing the at least one electro-withdrawing group can be synthesized by condensation reaction of tetracarboxylic dianhydride and diamine, wherein at least one of tetracarboxylic dianhydride and diamine contains electro-withdrawing groups, or the first charge passivation layer 141 of polyimide containing the at least one electro-withdrawing group can be synthesized by mixing tetracarboxylic dianhydride, diamine, and alcohol containing electro-withdrawing groups to form electro-withdrawing group substituents on tetracarboxylic dianhydride or diamine during condensation reaction. Specifically, the material of the first charge passivation layer 141 includes a constituent element represented by -X-Y-, wherein group X represents a constituent unit derived from tetracarboxylic dianhydride, and group Y represents a constituent unit derived from diamine. The group X includes a first constituent unit derived from tetracarboxylic dianhydride, the group Y includes a second constituent unit derived from diamine, and at least one of the first constituent unit and the second constituent unit contains electro-withdrawing groups.

Tetracarboxylic dianhydride can be selected from tetracarboxylic dianhydrides represented by formulas (X1) to (X7):

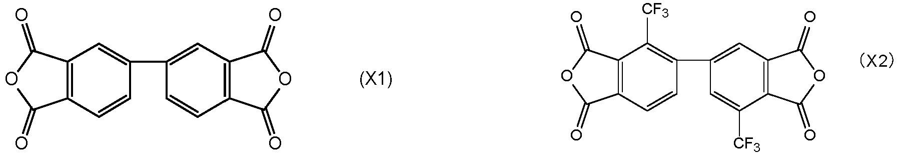

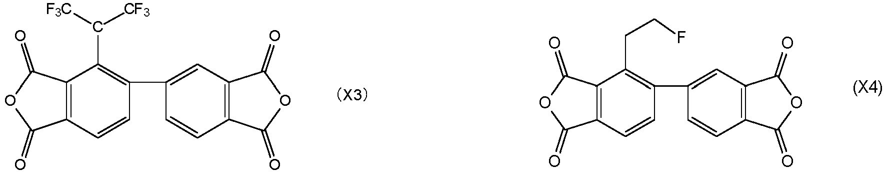

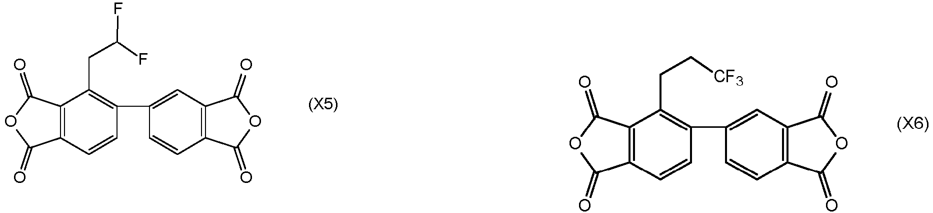

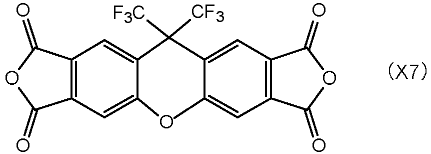

Diamine can be selected from diamines represented by formulas (Y1) to (Y3):

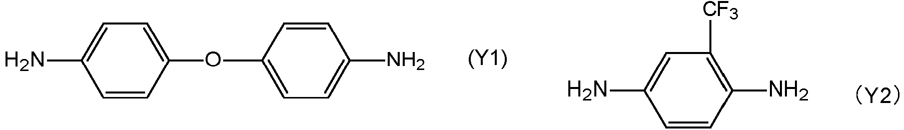

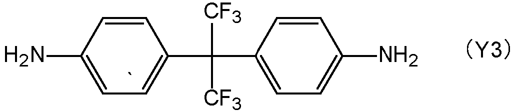

It should be noted that, tetracarboxylic dianhydrides and diamines with electro-withdrawing groups containing fluorine are taken for examples as the tetracarboxylic dianhydrides represented by formulas (X1) to (X7) and the diamines represented by formulas (Y1) to (Y3), but the tetracarboxylic dianhydrides and the diamines of the present application should not be limited to these.

Thermal stability of electro-withdrawing groups containing fluorine is relatively poor, they would be enriched at the interface during curing, and form hydrogen bonds with OH- or other groups, so as to form the first charge passivation layer 141 on a surface. Furthermore, addition of electro-withdrawing groups may affect thermal stability of polyimides. Therefore, besides the constituent unit derived from tetracarboxylic dianhydride which contains electro-withdrawing groups and the constituent unit derived from diamine which contains electro-withdrawing groups, the first charge passivation layer 141 can also include a constituent unit derived from tetracarboxylic dianhydride which is free of electro-withdrawing groups and a constituent unit derived from diamine which is free of electro-withdrawing groups, to ensure the thermal stability of polyimides. Specifically, the first charge passivation layer 141 further includes a third constituent unit derived from tetracarboxylic dianhydride, and/or a fourth constituent unit derived from diamine. Among the first constituent unit and the third constituent unit, a mass percentage of a constituent unit containing electro-withdrawing groups accounts for 2% to 6% of a mass percentage of the first constituent unit and the third constituent unit, preferably, accounts for 3% to 6%; and/or among the second constituent unit and the fourth constituent unit, a mass percentage of a constituent unit containing electro-withdrawing groups accounts for 2% to 6% of a mass percentage of the second constituent unit and the fourth constituent unit, preferably, accounts for 3% to 6%. When the mass percentage of the constituent units containing electro-withdrawing groups accounts for more than 6% of the mass percentage of the first to fourth constituent units, outgassing might be induced, which may affect thermal stability. When the mass percentage of the constituent units containing electro-withdrawing groups accounts for less than 2% of the mass percentage of the first to fourth constituent units, an effect of charge passivation might be weakened.

Several different examples are described in detail as below.

In one embodiment, the first charge passivation layer 141 includes a constituent unit represented by the following formulas:
-Ya-Xa-Ya-, -Ya-Xb-Ya-, wherein Xa is defined as the first constituent unit derived from tetracarboxylic dianhydride being free of the electro-withdrawing group, Xb is defined as the third constituent unit derived from tetracarboxylic dianhydride containing electro-withdrawing group, and Ya is defined as the second constituent unit derived from diamine being free of the electro-withdrawing group. Wherein, a mass percentage of Xb accounts for 2% to 6% of a total mass percentage of Xa and Xb.

In one embodiment, the first charge passivation layer 141 includes a constituent unit represented by the following formulas:
-Ya-Xa-Ya-, -Yb-Xa-Yb-, and -Ya-Xa-Yb-, wherein Xa is defined as the first constituent unit derived from tetracarboxylic dianhydride being free of the electro-withdrawing group, Ya is defined as the second constituent unit derived from diamine being free of the electro-withdrawing group, and Yb is defined as the fourth constituent unit derived from diamine containing electro-withdrawing group. Wherein, a mass percentage of Yb accounts for 2% to 6% of a total mass percentage of Ya and Yb.

In one embodiment, the first charge passivation layer 141 includes a constituent unit represented by the following formulas:
-Ya-Xa-Ya-, -Ya-Xb-Ya-, -Yb-Xa-Yb-, -Yb-Xb-Yb-, and Ya-Xa-Yb-, wherein Xa is defined as the first constituent unit derived from tetracarboxylic dianhydride being free of the electro-withdrawing group, Xb is defined as the third constituent unit derived from tetracarboxylic dianhydride containing electro-withdrawing group, Ya is defined as the second constituent unit derived from diamine being free of the electro-withdrawing group, and Yb is defined as the fourth constituent unit derived from diamine containing electro-withdrawing group. Wherein, the mass percentage of Xb accounts for 2% to 6% of the total mass percentage of Xa and Xb, and the mass percentage of Yb accounts for 2% to 6% of the total mass percentage of Ya and Yb, so that the mass percentage of the constituent unit containing electro-withdrawing group accounts for 2% to 6% of the total mass percentage of the first constituent unit to the fourth constituent unit.

Optionally, the first charge passivation layer 141 can be independently arranged on the first organic substrate 11, that is, the first organic substrate 11 is formed firstly, and then the first charge passivation layer 141 is formed on the first organic substrate 11. It should be noted that, as long as the first charge passivation layer 141 can be formed on the surface of the first organic substrate 11, a forming method of the first charge passivation layer 141 is not limited in the present application. The material of the first charge passivation layer 141 can be made of other materials than polyimide containing electro-withdrawing groups.

Optionally, the material of the first charge passivation layer 141 includes a constituent element represented by any one of the following formulas (1) to (3): 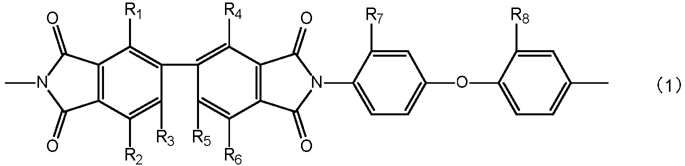 wherein in formula (1), R₁ to R₈ are independently selected from H and fluorine-containing substituents, respectively, and at least one of R₁ to R₈ is a fluorine-containing substituent; 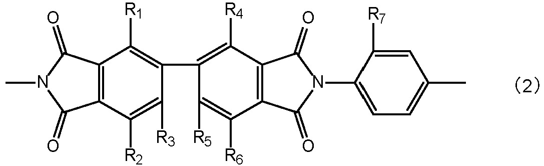 wherein in formula (2), R₁ to R₇ are independently selected from H and fluorine-containing substituents, respectively, and at least one of R₁ to R₇ is a fluorine-containing substituent; 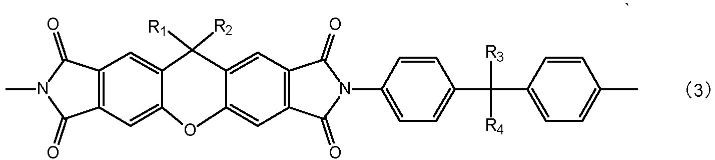 wherein in formula (3), R₁ to R₄ are independently selected from H and fluorine-containing substituents, respectively, and at least one of R₁ to R₄ is a fluorine-containing substituent.

Specifically, the fluorine-containing substituents may be fluorine atom or trifluoromethyl.

During a curing process of fluorine-containing polyimide, fluorine atoms will migrate spontaneously and gather on a surface of polyimide. The principle of intramolecular and intermolecular CTC being weakened is that strong electro-withdrawing groups such as fluorine are introduced into the molecule, resulting in the weakening of intramolecular and intermolecular electron delocalization and electrons being trapped by the fluorine atoms. Intramolecular and intermolecular delocalization effect is weakened, so that the polyimide polarization is prevented. Furthermore, when fluorine-containing substituents are defined as trifluoromethyl, as trifluoromethyl has a three-dimensional configuration, steric hindrance is increased, the intermolecular delocalization effect is weakened, and polarization of polyimide is further prevented. During the operation of the thin film transistor devices arranged on the substrate 10, an electric field applied to an interface between the polyimide substrate and the thin film transistor devices cannot induce electrons in the polyimide to move freely, so as to effectively improve polarization of a traditional polyimide material under the action of electric field, so as to weaken the influence of the polyimide substrate on threshold voltages of the thin film transistors, achieving an effect of improving long-term image sticking.

More specifically, the material of the first charge passivation layer 141 includes a constituent element represented by any one of the following formulas (4) to (10):

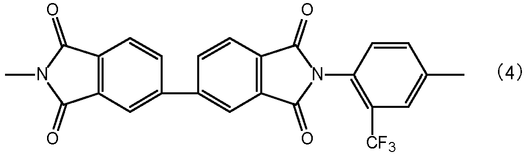

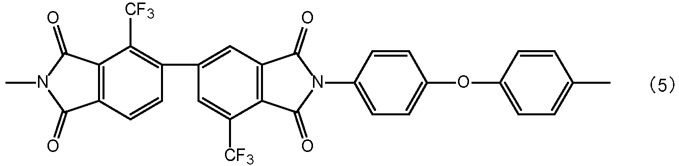

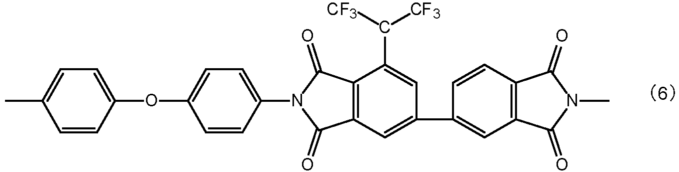

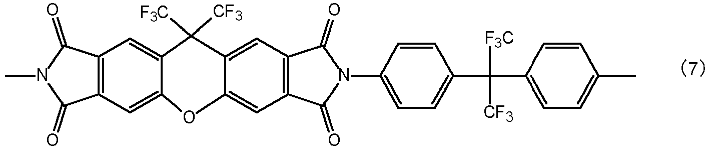

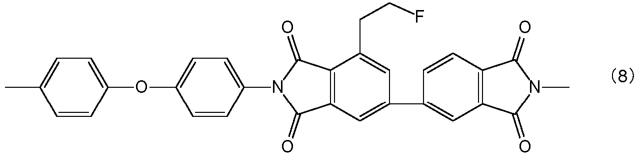

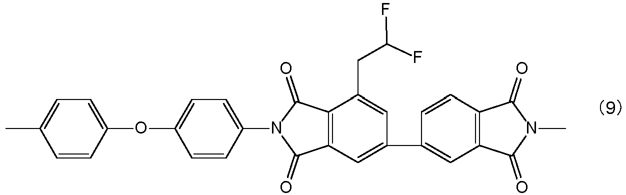

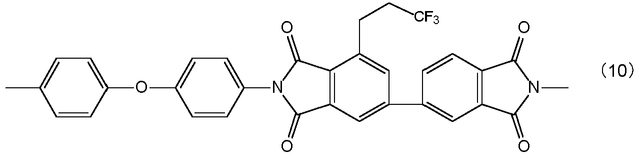

The materials of the first charge passivation layer 141 including the constituent element represented by any one of the following formulas (4) to (10) can be easily synthesized from commercially available materials.

It should be noted that that polyimide including the constituent elements represented by formula (7) can be defined as porous 6FXDA/6FDAm polyimide nanofoam of nano size.

Optionally, the first charge passivation layer 141 is integrated with the first organic substrate 11. The first charge passivation layer 141 can be made in a same process as the first organic substrate 11 to simplify manufacturing processes and improving bonding force between the first charge passivation layer 141 and the first organic substrate 11. Certainly, the first charge passivation layer 141 and the first organic substrate 11 can also be isolated and manufactured by different processes.

The manufacturing method and advantages of the polyimide substrate according to one embodiment of the present application are described below.

One of the manufacturing methods of the polyimide substrate of the present application is to form a polyimide film with a charge passivation layer including fluorine-containing polyimide on the surface thereof. The manufacturing can be performed in the following three ways:
1) In a process of synthesizing tetracarboxylic dianhydride monomer and diamine monomer, fluorine-containing diamine monomer is introduced, but relative content of fluorine-containing diamine monomer (a mass percentage of fluorine-containing diamine monomer accounting for a mass percentage of fluorine-containing diamine monomer and fluorine-free diamine monomer) is controlled not to exceed 6%, fluorine-containing polyamic acid is generated, and then turns to polyimide through imidization.
2) In a process of synthesizing tetracarboxylic dianhydride monomer and diamine monomer, fluorine-containing tetracarboxylic dianhydride monomer is introduced, but relative content of fluorine-containing tetracarboxylic dianhydride monomer (a mass percentage of fluorine-containing tetracarboxylic dianhydride monomer accounting for a mass percentage of fluorine-containing tetracarboxylic dianhydride monomer and fluorine-free tetracarboxylic dianhydride monomer) is controlled not to exceed 6%, fluorine-containing polyamic acid is generated, and then turns to polyimide through imidization.
3) In a synthesis process of dianhydride and diamine monomer reacting while stirring, fluorine-containing small molecules are introduced to form fluorine-containing polyamic acid, and polyimide is formed by imidization.

Processes of turning polyamic acid to polyimide by imidization are: forming a wet film of polyamic acid by coating, conducting HVCD (rapid vacuum drying) to remove solvent after the coating of wet film to fix the shape of the wet film, and then curing the wet film at a high temperature to form fluorine-containing polyimide film. Wherein HVCD is performed under such conditions: a temperature of 40 to 80°C, a pressure of 0 to 10Pa, and a duration of 250 to 550 seconds. Curing temperature is 400 to 450 °C, and curing duration is 13 minutes.

### Example 1

Biphenyltetracarboxylic dianhydride, 4,4'-diaminodiphenyl ether, and 1-trifluoromethyl-p-phenylenediamine are dissolved in N-methylpyrrolidone (NMP) at a mass percentage of 100:98:2, reaction is carried out with stirring to generate polyamic acid, then the polyamic acid is imidized to form polyimide film, and finally the properties of polyimide film are tested. The reaction formula of forming polyimide film is illustrated as following:

The synthesized polyimide film is used as the substrate 10. As described above, the 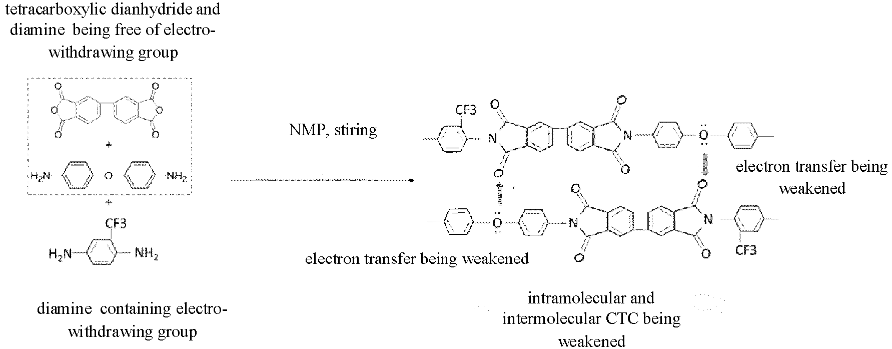 substrate 10 includes a first organic substrate 11 and a second organic substrate 12. A thickness of the first organic substrate 11 ranges from 5 microns to 15 microns, and a thickness of the second organic substrate 12 ranges from 5 microns to 10 microns.

A SiOx layer is deposited on the substrate 10, and then the thin film transistor layer 30 is prepared thereon, and long-term image sticking is tested. Long-term image sticking is tested by means of testing an initial Just Notice Differences (JND) value after a checkerboard being lighted on the screen and aging for 10 minutes.

In addition, an EDX scanning and an EDX surface scanning were also performed on the first organic substrate 11 of embodiment 1.

### Example 2

Biphenyltetracarboxylic dianhydride, 2,2' - difluoromethyl-4,4', 5,5' - biphenyltetracarboxylic dianhydride, 4,4'- diaminodiphenyl ether are dissolved in NMP at a mass percentage of 97:3:100, reaction is carried out with stirring to generate polyamic acid, then the polyamic acid is imidized to form polyimide film, and finally the properties of polyimide film are tested. The reaction formula of forming polyimide film is illustrated as following:

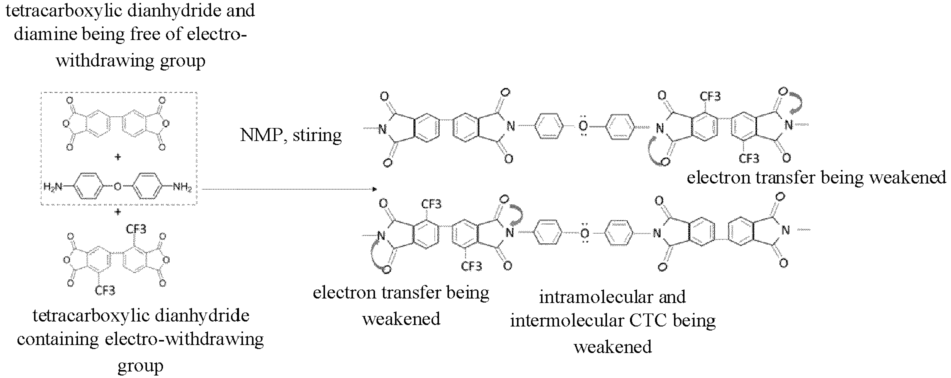

The synthesized polyimide film is used as the substrate 10. As described above, the substrate 10 includes a first organic substrate 11 and a second organic substrate 12. The thickness of the first organic substrate 11 ranges from 5 microns to 15 microns, and the thickness of the second organic substrate 12 ranges from 5 microns to 10 microns.

A SiOx layer is deposited on the substrate 10, and then the thin film transistor layer 30 is prepared thereon, and long-term image sticking is tested. Long-term image sticking is tested by means of testing the initial JND value after a checkerboard being lighted on the screen and an aging for 10 minutes.

### Example 3

Biphenyltetracarboxylic dianhydride, 4,4'-diaminodiphenyl ether, and Fluoroethanol are dissolved in NMP at a mass percentage of 100:100:6, reaction is carried out with stirring to generate polyamic acid, then the polyamic acid is imidized to form polyimide film, and finally the properties of polyimide film are tested. The reaction formula of forming polyimide film is illustrated as following:

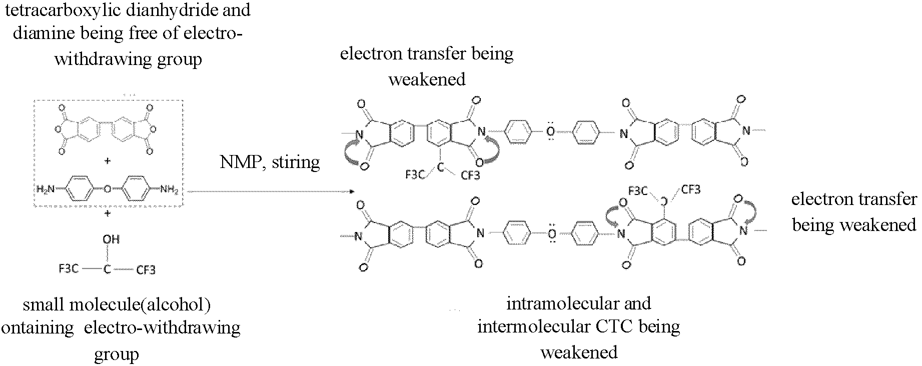

The synthesized polyimide film is used as the substrate 10. As described above, the substrate 10 includes a first organic substrate 11 and a second organic substrate 12. The thickness of the first organic substrate 11 ranges from 5 microns to 15 microns, and the thickness of the second organic substrate 12 ranges from 5 microns to 10 microns.

A SiOx layer is deposited on the substrate 10, and then the thin film transistor layer 30 is prepared thereon, and long-term image sticking is tested. Long-term image sticking is tested by means of testing the initial JND value after a checkerboard being lighted on the screen and an aging for 10 minutes.

### Comparative example

A regularly synthesized polyimide film is used as the substrate. As described above, the substrate includes two polyimide substrate. A thickness of a polyimide substrate facing away from the thin film transistor ranges from 5 microns to 15 microns, and a thickness of a polyimide film close to the thin film transistor ranges from 5 microns to 10 microns.

A SiOx layer is deposited on the substrate, and then the thin film transistor layer is prepared thereon, and long-term image sticking is tested. Long-term image sticking is tested by means of testing the initial JND value after a checkerboard being lighted on the screen and an aging for 10 minutes.

Besides, an EDX surface scanning were also performed on the polyimide substrate facing away from the thin film transistor.

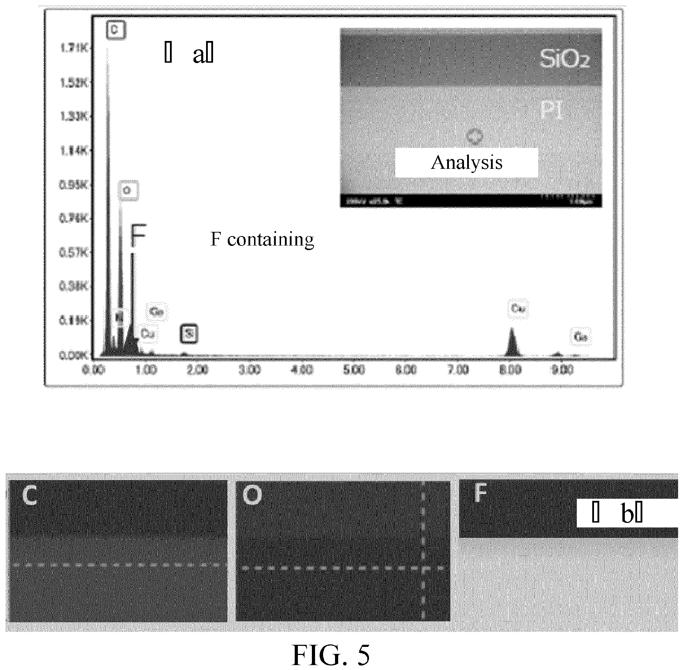

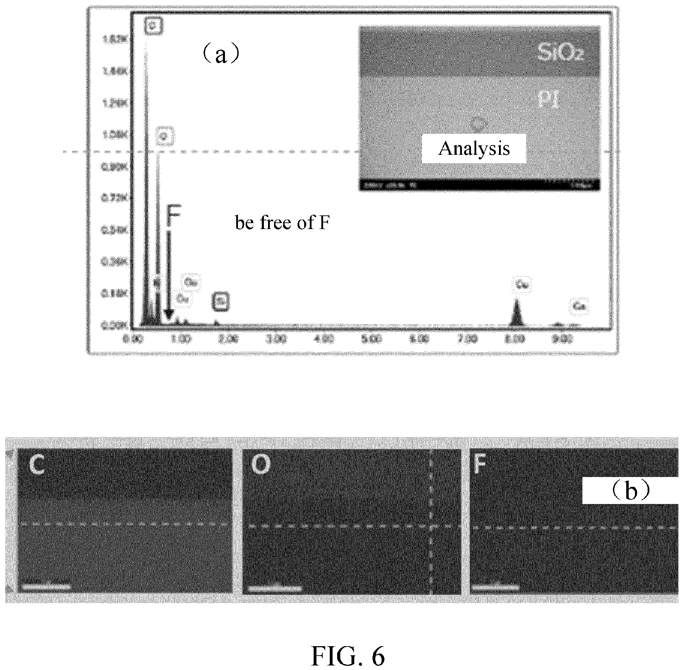

Please refer to FIG. 5 (a), FIG. 5 (a) proves successful synthesis of fluorine-containing polyimide in example 1, and a brighter part in the third figure of FIG. 5 (b) shows content and distribution of fluorine atoms in a first polyimide substrate. Please refer to FIG. 6 (a), FIG. 6 (a) shows that the polyimide in the comparative example does not contain fluorine, and the third figure of FIG. 6 (b) shows that the polyimide substrate is free of fluorine atom.

Property data of examples 1 to 3 and the comparative example are as follows.

**Table 1 property data of polyimide in Examples 1 to 3**

| Evaluation items | | Unit | Comparative example | Example 1 | Example 2 | Example 3 |
|---|---|---|---|---|---|---|
| Coefficient of thermal expansion (CTE)(50m N) | 50 to 400 °C | ppm/ °C | 3.5 | 4.3 | 4.4 | 4.0 |
| | 50 to 450 °C | ppm/ °C | 4.1 | 5.2 | 5.5 | 5.3 |
| TD 1% (temperature when thermal weight loss up to 1%) | | °C | 570 | 556 | 550 | 561 |
| Residual Stress | | Mpa | 5 | 7 | 6.5 | 6.6 |
| Tensile Stress | | Mpa | 380 | 360 | 366 | 370 |
| Elongation | | % | 25 | 18 | 17 | 16 |
| Transmittance (Tr, 380 nm to 780 nm) | | % | 73 | 82 | 79 | 80 |
| Dielectric constant | | farad/ meter | 3.2 | 2.7 | 2.6 | 2.5 |

It can be acknowledged from table 1 that characteristics of fluorine-containing polyimide materials do not have significant difference compared with traditional polyimides, and dielectric constant of polyimide films in examples 1 to 3 is decreased compared with traditional polyimides, which is less than or equal to 2.7. Moreover, with increasing of content of F atom, the dielectric constant of fluorine-containing polyimide films decreases gradually. The transmittance of the polyimide films of examples 1 to 3 to the light of 380 nm to 780 nm is greater than or equal to 79%. Compared with the existing polyimide, the transmittance is slightly improved, which is more conducive to being used as the substrate material of an OLED backplane for under screen camera.

Referring to FIG. 7, fluorine-containing polyimide films are used as the substrates of the array substrates in examples 1 to 3. Significant threshold voltage shift will not occur when the thin film transistor devices are under the stress of voltage and temperature, so as to effectively solve the problem of serious long-term image sticking caused by great threshold voltage shift during the operation of thin film transistor devices when traditional polyimide materials are used as the substrate of the array substrate. Due to existence of electro-withdrawing groups such as fluorine, fluorine-containing polyimide has a relatively small dielectric constant. Polarization ability of polyimide under the stress of voltage and temperature is weak. Even after the polarization of polyimide, separation of charges is slow, and the threshold voltage shift of the corresponding thin film transistor devices under the stress of voltage and temperature is small, and recovery is slow, so that long-term image sticking can be effectively improved.

In the above embodiments, it is explained that a substrate with two polyimide films containing electro-withdrawing groups has a stronger capability to trap electrons. It can be understood that in other embodiments of the present application, it is only necessary for at least one of the first organic substrate 11 and the second organic substrate 12 to dispose a charge passivation layer on its surface close to the thin film transistor layer 30.

Optionally, the substrate 10 of the present application includes a single-layered polyimide substrate and one charge passivation layer. Wherein a thickness of the single-layered polyimide substrate is 15 microns or 12 microns.

Please refer to FIG. 8, a difference between a second embodiment of the present application and the first embodiment includes:

The first inorganic layer 20 is a barrier layer. The barrier layer includes a stack of silicon nitride, silicon oxide, and a-Si. In addition, the charge passivation layer 24 is disposed between the buffer layer BL and the first inorganic layer 20.

In the second embodiment of the present application, a charge passivation layer is also disposed between the barrier layer and the thin film transistor, it is effective in preventing electrons from moving and reducing the influence of polarization of organic substrates on the thin film transistors.

As a modified example of the present application, the buffer layer BL includes silicon nitride, silicon oxide, or a stack of silicon nitride and silicon oxide. The barrier layer includes a stack of silicon nitride, silicon oxide, and a-Si. Each layer within the buffer layer BL or the barrier layer 3L can be named the first inorganic layer 20. The flexible display panel 100 can also include at least one charge passivation layer 24, and the at least one first charge passivation layer 24 is disposed between the first inorganic layer 20 and the thin film transistor layer 30. That is to say, the charge passivation layer 24 can be configured outside of the buffer layer BL and the barrier layer 3L, or inside of the buffer layer BL and the barrier layer 3L.

The above description provides a detailed introduction to the application. In the present application, specific examples are applied to explain principle and embodiments of the application. The description of the above embodiments is only used to help understand the application. At the same time, for those skilled in the art, according to the thought of the present application, there will be changes in the specific embodiments and application scope. In conclusion, the content of the specification should not be understood as the limitation of the present application.

## Claims

1. A flexible display panel, comprising:
a first organic substrate;
a charge passivation layer disposed on a side of the first organic substrate, wherein the charge passivation layer comprises at least one electro-withdrawing group;
a first inorganic layer disposed on a side of the charge passivation layer facing away from the first organic substrate; and
a thin film transistor layer disposed on a side of the first inorganic layer facing away from the first organic substrate.

2. The flexible display panel according to claim 1, wherein the charge passivation layer is disposed on a surface of a side of the first organic substrate close to the thin film transistor layer.

3. The flexible display panel according to claim 1, wherein the flexible display panel further comprises:
a second inorganic layer disposed between the first organic substrate and the first inorganic layer; and
a second organic substrate disposed between the second inorganic layer and the first inorganic layer;
wherein the charge passivation layer is disposed between the first organic substrate and the second inorganic layer, and/or, the charge passivation layer is disposed between the second organic substrate and the first inorganic layer.

4. The flexible display panel according to claim 3, wherein the charge passivation layer is disposed on a surface of a side of the second organic substrate close to the thin film transistor layer.

5. The flexible display panel according to claim 3, wherein the charge passivation layer is obtained by performing a charge passivation process on a same organic material as the first organic substrate, or the charge passivation layer is obtained by performing a charge passivation process on a same organic material as the second organic substrate.

6. The flexible display panel according to claim 5, wherein the charge passivation layer is obtained by fluorination of the same organic material as the first organic substrate, or the charge passivation layer is obtained by fluorination of the same organic material as the second organic substrate.

7. The flexible display panel according to claim 5, wherein the first organic substrate comprises the same organic material as the second organic substrate.

8. The flexible display panel according to claim 5, wherein a dielectric constant of the charge passivation layer is less than or equal to 2.7, and a transmittance of the charge passivation layer of light of 380 nm to 780 nm is greater than or equal to 79%.

9. The flexible display panel according to claim 1, wherein the charge passivation layer comprises a constituent element represented by -X-Y-, wherein, group X comprises a first constituent unit derived from tetracarboxylic dianhydride, group Y comprises a second constituent unit derived from diamine, and at least one of the first constituent unit and the second constituent unit comprises the at least one electro-withdrawing group; and
the at least one electro-withdrawing group is selected from at least one of nitro group, trifluoromethyl, trichloromethyl, tribromomethyl, triiodomethyl, cyano group, sulfonic acid group, fluorine atom, chlorine atom, bromine atom, and iodine atom.

10. The flexible display panel according to claim 9, wherein the charge passivation layer further comprises a third constituent unit derived from tetracarboxylic dianhydride and/or a fourth constituent unit derived from diamine, among the first constituent unit and the third constituent unit, a mass percentage of a constituent unit containing electro-withdrawing groups accounts for 2% to 6% of a mass percentage of the first constituent unit and the third constituent unit; and/or
among the second constituent unit and the fourth constituent unit, a mass percentage of a constituent unit containing electro-withdrawing groups accounts for 2% to 6% of a mass percentage of the second constituent unit and the fourth constituent unit.

11. The flexible display panel according to claim 10, wherein a material of the charge passivation layer comprises a constituent element represented by any one of the following formulas (1) to (3): 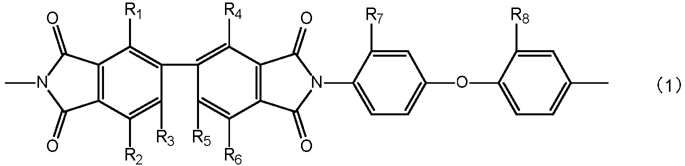 wherein in formula (1), R₁ to R₈ are independently selected from H and fluorine-containing substituents, respectively, and at least one of R₁ to R₈ is a fluorine-containing substituent; 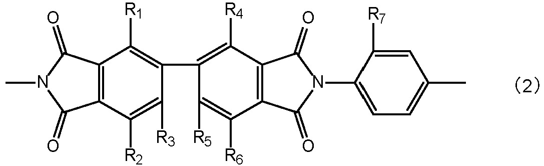 wherein in formula (2), R₁ to R₇ are independently selected from H and fluorine-containing substituents, respectively, and at least one of R₁ to R₇ is a fluorine-containing substituent; 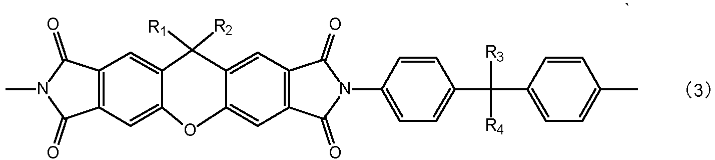 wherein in formula (3), R₁ to R₄ are independently selected from H and fluorine-containing substituents, respectively, and at least one of R₁ to R₄ is a fluorine-containing substituent.

12. The flexible display panel according to claim 11, wherein the material of the charge passivation layer comprises a constituent element represented by any one of the following formulas (4) to (10):
